# EUROPEAN PATENT SPECIFICATION

(11) **EP 2 264 225 B1**
(45) Date of publication and mention of the grant of the patent: **29.08.2012**
(21) Application number: 09305570.5
(22) Date of filing: 18.06.2009
(51) Int. Cl.: C30B 23/02, C23C 14/56, C30B 29/40

(54) **Molecular beam epitaxy apparatus for producing wafers of semiconductor material**
Vorrichtung für epitaxialen Molekularstrahlprozess zum Herstellen von Wafern aus Halbleitermaterial
Appareil d'épitaxie à faisceau moléculaire pour la production de tranches de matériau semi-conducteur

(43) Date of publication of application: 22.12.2010
(73) Proprietor: Riber, 95870 Bezons (FR)
(72) Inventor: Villette, Jérome, 92350 Le Plessis Robinson (FR); Chaix, Catherine, 78170 Saint-Cloud (FR); Cassagne, Valerick, 91470 Limours en Hurepoix (FR)
(74) Representative: Michelet, Alain

(56) References cited:
- EP-A- 2 060 662
- WO-A-2008/039410
- FR-A- 2 840 925
- US-A- 5 711 813

## Description

The present invention relates to a molecular beam epitaxy apparatus for producing wafers of semiconductor material.

Epitaxial gallium nitride (GaN) semiconductor has shown very interesting semi conducting properties for high power and high frequency applications such as high luminescence LED or radiofrequence transistors.

The epitaxy of thin layers of GaN can be done by two main techniques namely, Molecular Beam Epitaxy (MBE) and Metal Organic Chemical Vapor Deposition (MOCVD).

In the case of molecular beam epitaxy technique, atoms or molecules of elements or compounds, for instance Gallium, is evaporated from a melted metal in an effusion cell and the nitrogen element can be supplied by molecular nitrogen cracked by a plasma source or from ammonia in gaseous state from a gas injector which decomposes chemically at the surface of the substrate by thermal activation.

A molecular beam epitaxy apparatus usually comprises a loading compartment wherein a substrate to be coated is introduced, a compartment wherein the substrate is dehydrated, a compartment wherein an operation of deoxidation of the substrate is performed, a growth chamber and a pumping means pumping the residual elements of the growth chamber.

The substrate, silicon for instance, is introduced in the growth chamber wherein a vacuum of about 10⁻⁸ Pascal is performed. The substrate is heated at a temperature between about 300°C and 1100°C. Then, gaseous precursor like ammonia is injected in the growth chamber and the metal in the effusion cell is heated to be evaporated. Gaseous ammonia reacts with the evaporated metal at the surface of the substrate to form an epitaxial layer of GaN.

A part of the ammonia which is not cracked during the growth process is trapped on the cryogenic panel covering the inner surface of the lateral wall of the growth chamber and surrounding the process area.

Because of:
- the pressure of ammonia used between 10⁻⁵ and 10⁻² Pascal during injection step,
- the temperature of the growth chamber inner walls around room temperature,
- the large area of these walls compared to the volume of the growth chamber, and
- the adsorption/desorption energy of ammonia on solids about 75 to 125 kJ/mol,
the ammonia molecules adsorb easily on the growth chamber walls, which are usually sensibly at room temperature, and desorb with a time constant of minutes to hours.

It induces a no negligible vapor pressure and flow of ammonia in the system when ammonia injection is stopped. This residual ammonia may disturb the other processes ran in the growth chamber when ammonia is not desired.

As an example, when silicon substrates are used, an important background of ammonia pressure during the heat-up of the substrate nitrides its surface converting silicon into silicon nitride and so affects its electrical properties.

Examples of vacuum deposition apparatuses having a growth chamber comprising a cryogenic panel in order to pump the residual elements present in the growth chamber can be found in documents WO2008/039410 et US571181.

The object of the present invention is to provide a molecular beam epitaxy apparatus as set forth in claim 1 enabling to reduce efficiently the pressure of gaseous precursor in the growth chamber under a pressure limit, when gaseous precursor is not desired. This pressure limit corresponds to a gaseous precursor pressure under which the perturbation of the growth process by the precursor is limited or avoided.

To this end, the invention concerns a molecular beam epitaxy apparatus for producing wafers of semiconductor material comprising a substrate covered by a layer of material, said device further comprising:
- a growth chamber surrounding a process area, said growth chamber comprising a lateral wall, a lower wall and an upper wall having each an inner surface,
- a main cryogenic panel having at least a lateral part covering the inner surface of said lateral wall,
- a sample holder able to support said substrate, said sample holder comprising heating means,
- at least one effusion cell able to evaporate atoms or molecules of elements or compounds,
- a gas injector able to inject into the growth chamber a gaseous precursor, a part of said gaseous precursor being able to react with the evaporated atoms or molecules of elements or compounds on the surface of the substrate to form the layer,
- pumping means connected to the growth chamber and able to provide high vacuum capability.

According to the invention, the molecular beam epitaxy apparatus comprises an insulation enclosure covering at least the inner surfaces of the growth chamber walls, said insulation enclosure comprising cold parts having a temperature Tₘᵢₙ inferior or equal to melting point of the gaseous precursor, and hot parts having a temperature Tₘₐₓ superior or equal to a temperature wherein the desorption rate of the gaseous precursor on said hot parts is at least 1000 times greater than the adsorption rate of said gaseous precursor.

The temperature of cold parts Tₘᵢₙ is sufficiently low to trap the gaseous precursor and not release this last. The temperature of hot parts Tₘₐₓ is sufficiently high for avoiding fixation of gaseous precursor thereof.

The invention permits to shield the process area from the gaseous precursor desorbing from the growth chamber walls which are usually at room temperature (usually a temperature not comprised in the range between Tₘᵢₙ and Tₘₐₓ), reducing or eliminating the perturbation of the process when gaseous precursor is not needed. The invention allows limiting the residual vapor pressure of the gaseous precursor (ammonia for instance) into the growth chamber. Pollution of the substrate, the effusion cell, the gas injector and the pressure gauge, is avoided.

According to various embodiments, the present invention also concerns the characteristics below, considered individually or in all their technical possible combinations:
- the effusion cell is able to evaporate atoms or molecules of elements or compounds of the group III and the gas injector is able to inject a gaseous precursor comprising an element of the group V,
- the substrate is a silicon substrate, the effusion cell is able to evaporate gallium and the gas injector is able to inject gaseous ammonia,
- the temperature of said cold parts Tₘᵢₙ is inferior or equal to -78°C, and the temperature of said hot parts Tₘₐₓ is superior or equal to +100°C,
- said cold parts of the insulation enclosure comprises:
   o said lateral part of the main cryogenic panel covering the inner surface of the lateral wall, said lateral part of the main cryogenic panel being provided with a hole for the connection with the pumping means,
   o a lower part of the main cryogenic panel covering the inner surface of the lower wall, said lower part of the main cryogenic panel being provided with a first hole for the effusion cell, and a second hole for the gas injector,
   o an upper part of the main cryogenic panel covering the inner surface of the upper wall, said upper part of the main cryogenic panel being provided with a hole crossed by said sample holder,
- said pumping means comprising a pumping duct, said cold parts of the insulation enclosure comprise a cryogenic panel covering the wall inner surface of the pumping duct,
- the insulation enclosure covers at least 80% of the inner surfaces of the growth chamber walls and the pumping duct of the pumping well,
- said effusion cell comprising a shutter and said gas injector comprising heating means, said hot parts of the insulation enclosure comprise said effusion cell, said gas injector, said sample holder, and the shutter of the effusion cell,
- said molecular beam epitaxy apparatus comprising a secondary cryogenic panel and said lateral part of the main cryogenic panel comprising an upper end, said cold parts of the insulation enclosure comprise a first thermal wing linked to said upper end of the lateral part of the main cryogenic panel, and a second thermal wing linked to the outer wall of the secondary cryogenic panel, said two thermal wings, extending transversally, surrounding the secondary cryogenic panel and being close one to each other such as to insulate the process area from the upper wall of the growth chamber,
- said cold parts of the insulation enclosure comprise a fourth thermal wing positioned into the second hole of the lower part of the main cryogenic panel and extending from said hole,
- said hot parts of the insulation enclosure comprise a third thermal wing linked to the gas injector, said third thermal wing being positioned between the second hole of the lower part of the main cryogenic panel and the inner surface of the lower wall of the growth chamber, and surrounding the gas injector such as to insulate the process area from the inner surface of the lower wall of the growth chamber,
- the insulation enclosure is separated from the growth chamber walls by a space d, such that condensed precursor on cold parts of said insulation enclosure does not touch said growth chamber walls,
- the sample holder is lower than the lower end of the secondary cryogenic panel for limiting or avoiding thermal exchanges between said sample holder and the lower end of said secondary cryogenic panel.

The description of the invention is illustrated by the following drawings in which:
- Figure 1 represents a molecular beam epitaxy apparatus according to an embodiment of the invention;
- Figure 2 represents thermal wings according to an embodiment of the invention;
- Figure 3 represents thermal wings according to an other embodiment of the invention;

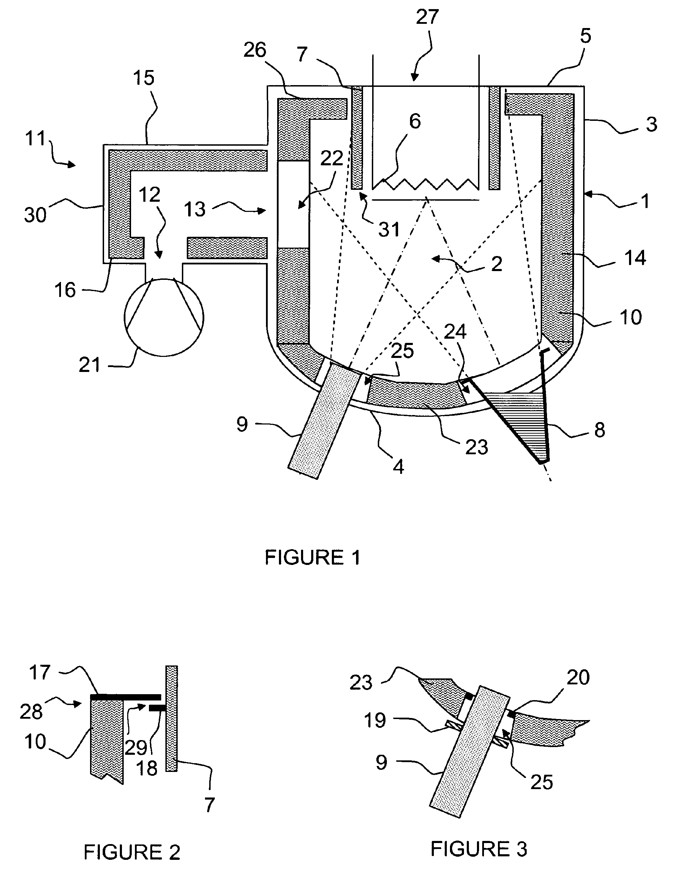

Figure 1 represents a molecular beam epitaxy apparatus according to an embodiment of the invention.

The molecular beam epitaxy apparatus comprises a growth chamber 1 surrounding a process area 2. The growth chamber 1 comprises a lateral wall 3, a lower wall 4 and an upper wall 5. Each of these walls has an inner surface. The growth chamber walls 3, 4, 5 form a unitary assembly having the general shape of a closed cylinder.

The molecular beam epitaxy apparatus comprises a main cryogenic panel having at least a lateral part 10 covering the inner surface of the lateral wall 3. This main cryogenic panel 10 is cooled with a cryogenic fluid like liquid nitrogen, for example. Glycol can also be used as cryogenic fluid. Preferably, the lateral part of the main cryogenic panel 10 has a cylindrical shape.

The molecular beam epitaxy apparatus comprises a sample holder 6 which can be eventually surrounded by a secondary cryogenic panel 7 having a cylindrical shape. The sample holder 6 is positioned at the top of the growth chamber 1 and supports the substrate. It comprises heating means for heating the substrate at a temperature between 300°C to 1100°C.

The molecular beam epitaxy apparatus comprises at least one effusion cell 8 able to evaporate atoms or molecules of elements or compounds, and a gas injector 9 able to inject a gaseous precursor into the growth chamber 1. The effusion cell 8 and the gas injector 9 are positioned at the bottom of the growth chamber 1.

A part of the gaseous precursor is able to react with the evaporated atoms or molecules of elements or compounds on the surface of the substrate to form an epitaxial layer of material like GaN for example, and an other part of the gaseous precursor is not consumed.

The substrate can be silicon, silicon carbide, sapphire, aluminium nitride, diamond, gallium nitride templates, for instance.

The atoms or molecules of elements or compounds to be evaporated can be a metal of the group III and the element to be injected can be an element of the group V, for instance.

Preferably, the molecular beam epitaxy apparatus is used to obtain an epitaxial layer of GaN at the surface of a silicon substrate, the element of group III being gallium and the gaseous precursor comprising an element of the group V being ammonia (NH₃).

Each effusion cell 8 can comprise a movable shutter (not represented) and being made of various materials like alumina, for instance.

The molecular beam epitaxy apparatus comprises pumping means 11 connected to the growth chamber 1 and able to provide high vacuum capability.

The pumping means 11 can comprise a pumping duct 30 having a wall 15. The pumping duct 30 is connected to a pumping device 21 by a first end 12 and emerges into the growth chamber 1 by a second end 13.

The pumping device 21 can be a primary pump associated with a secondary pump.

The lateral part of the main cryogenic panel 10 is provided with a hole 22 positioned in front of the second end 13 of the pumping means 11.

According to an embodiment of the invention, the molecular beam epitaxy apparatus comprises insulation enclosure 14 covering at least the inner surfaces of the growth chamber walls 3, 4, 5.

The insulation enclosure 14 has cold parts and hot parts having temperatures such that the adsorption/desorption exchange process of the gaseous precursor is limited or avoided around the process area 2, in order to limit the partial pressure of the gaseous precursor in the growth chamber 1, when gaseous precursor is not desired.

The insulation enclosure 14 covers completely or nearly the inner surfaces of the growth chamber walls 3, 4, 5, in order to insulate the process area 2 from the inner surfaces of the growth chamber walls 3, 4, 5.

The temperature of cold parts Tₘᵢₙ is inferior or equal to the gaseous precursor melting point in order to trap the gaseous precursor not consumed on the cold parts.

The temperature of cold parts Tₘᵢₙ is such that the desorption time constant is high leading to negligible flow of ammonia in the process area 2. This temperature must be at least below to the melting point of the gaseous precursor, ammonia for instance.

For example, with a temperature below the ammonia melting point at - 78°C, desorption time constant is reduced by 5 orders of magnitude compared to room temperature. Thus, the contaminating flow into the process area 2 is reduced by this factor hundred thousand too. The temperature of cold parts must be sufficiently low to trap ammonia and not release this last.

Advantageously, at the temperature of liquid nitrogen (-196°C), there is a gain of 12 orders of magnitude.

Most of gaseous ammonia is trapped by cold parts. For ammonia, the pumping capacity of cold parts of insulation enclosure 14 is about 99% of the total pumping capacity. The residual species, which are not trapped by the cold parts, like nitrogen, carbon, water and hydrogen are pumped by the pumping means 11.

The temperature of the hot parts Tₘₐₓ are such that the desorption rate of gaseous precursor on hot parts is at least 1000 times greater than the adsorption rate of gaseous precursor. Said differently, the temperature of hot parts Tₘₐₓ is sufficiently high for avoiding fixation of gaseous precursor thereof.

The temperature of hot parts Tₘₐₓ is superior or equal to a temperature wherein the desorption time constant of the gaseous precursor is less than durations of transition periods of the processes, in order to limit the adsorption of the gaseous precursor on hot parts.

Typically, with transition time in the range of the minute, desorption time constant must be below the second. Concretely, on usual materials like stainless steel or tantalum, it needs a temperature Tₘₐₓ higher than +100°C.

To resume, when using ammonia as gaseous precursor, the temperature of cold parts Tₘᵢₙ is inferior or equal to -78°C, and the temperature of hot parts Tₘₐₓ is superior or equal to +100°C. The surfaces of the insulation enclosure 14 having a temperature between -78°C and +100°C are limited and preferably eliminated. Said differently, the temperature of the insulation enclosure 14 is not comprised in the range between Tₘᵢₙ and Tₘₐₓ, (-78°C and +100°C for ammonia).

Theses temperatures are different when using an other gaseous precursor like oxygen, for example.

The residual pressure of ammonia must be less than 10⁻⁷ Pascal, when ammonia is not needed, i. e before and after injection of gaseous ammonia in the growth chamber 1. This is the limit pressure under which the growth process is not perturbed, nor stopped. Preferably, the residual pressure of ammonia is about 10⁻⁸ Pascal. For comparison, during growth process, when gaseous precursor is injected, the residual pressure of ammonia is about 10⁻⁵ Pascal.

The main cryogenic panel comprises the lateral part 10 covering the inner surface of the lateral wall 3, a lower part 23 covering the inner surface of the lower wall 4 and an upper part 26 covering the inner surface of the upper wall 5.

The cold parts of the insulation enclosure 14 comprise the lateral part 10, the lower part 23, and the upper part 26 of the main cryogenic panel.

The lower part of the main cryogenic panel 23 is provided with a first hole 24 for the effusion cell 8, and a second hole 25 for the gas injector 9.

The upper part of the main cryogenic panel 26 is provided with a hole 27 crossed by the sample holder 6 and eventually by the secondary cryogenic panel 7 which surrounds this last.

In an other possible embodiment, the cold parts of the insulation enclosure 14 comprise a cryogenic panel 16 covering completely or nearly the wall 15 inner surface of the pumping duct 30 of the pumping means 11.

We mean by "covering" the fact that the cryogenic panel is disposed along the walls with a space d between these inner surfaces and the cryogenic panels, such that condensed precursor on cold parts does not touch the walls. The space d is between 0.5 cm and 5 cm.

Preferably, the lateral part of the main cryogenic panel 10, the lower part of the main cryogenic panel 23 and the upper part of the main cryogenic panel 26 of the growth chamber 1 form a unitary assembly wherein the cryogenic fluid circulates.

This unitary assembly is adapted to the form of the growth chamber walls 3, 4, 5.

The parts of the main cryogenic panel is designed to cover the most of the inner surfaces of the growth chamber walls 3, 4, 5. The holes in this cryogenic panel is filled with hot parts including, further, the sample holder 6, the effusion cell 8, the gas injector 9 comprising heating means and the shutter of the effusion cell.

Alternatively, the lateral part 10, the lower part 23 and the upper part of the main cryogenic panel 26 are three distinct cryogenic panels.

As seen on figure 1, advantageously, there is no direct view from the growth chamber walls which are sensibly at room temperature and usually at a temperature not comprised in the range between Tₘᵢₙ and Tₘₐₓ.

In a preferred manner, more than 80% of the growth chamber walls are shielded by hot and a cold parts of the insulation enclosure 14 facing the process area 2.

Alternatively, the lateral part of the main cryogenic panel 10 comprising an upper end 28, the cold parts of the insulation enclosure 14 comprise a first thermal wing 17 linked to the upper end 28 of the lateral part of the main cryogenic panel 10, as represented in figure 2.

The cold parts of insulation enclosure 14 comprise equally a second thermal wing 18 linked to the outer wall of the secondary cryogenic panel 7.

These two thermal wings 17, 18 extend transversally. The second thermal wing 18 extends transversally from the outer wall of the secondary cryogenic panel 7. These two thermal wings 17, 18 surround the secondary cryogenic panel 7 and are close one to each other such as to insulate the process area 2 from the upper wall 5 of the growth chamber 1.

A space 29 is provided between the two thermal wings 17, 18. Preferably, the thermal wings 17, 18 are ring-shaped.

The first thermal wing 17 extends from the lateral part of the main cryogenic panel 10 to the vicinity of the secondary cryogenic panel 7. A space is provided between the end of the first thermal wing 17 and the wall of the secondary cryogenic panel 7.

The second thermal wing 18 is positioned under the first thermal wing 17. The second thermal wing 18 is shorter than the first thermal wing 17 and is positioned in front of the space provided between the end of the first thermal wing 17 and the wall of the secondary cryogenic panel 7.

The thermal wings 17, 18 act as thermal conductor and are cooled by the cryogenic panels.

The hot parts of the insulation enclosure 14 comprise a third thermal wing 19 linked to the gas injector 9. The third thermal wing 19 is positioned between the second hole 25 of the lower part of the main cryogenic panel 23 and the inner surface of the lower wall 4 of the growth chamber 1. The third thermal wing 19 surrounds the gas injector 9 such as to insulate the process area 2 from the inner surface of the lower wall 4 of the growth chamber 1.

The third thermal wing 19 extends from the surface of the gas injector 9. It can be ring-shaped. Its width corresponds approximately to the diameter of the second hole 25 of the lower part of the main cryogenic panel 23.

The circulation of ammonia in vapor state is limited between the third thermal wing 19 and the lower part of the main cryogenic panel 23.

The cold parts of the insulation enclosure 14 comprise a fourth thermal wing 20 inserted into the second hole 24 of the lower part of the main cryogenic panel 23 and extending from the lower part of the main cryogenic panel 23. The fourth thermal wing 20 surrounds the gas injector 9 in order to insulate the process area 2 from the inner surface of the lower wall 4 of the growth chamber 1. The fourth thermal wing 20 can be ring-shaped.

In an other possible embodiment of the invention, the sample holder 6 is lower than the lower end 31 of the secondary cryogenic panel 7 for limiting or avoiding thermal exchanges between the sample holder 6 and the lower end 31 of the secondary cryogenic panel 7.

The invention allows limiting the residual vapor pressure of gaseous precursor into the growth chamber 1 when injection of gaseous precursor is stopped. Thus, the growth process is not perturbed.

## Claims

1. Molecular beam epitaxy apparatus for producing wafers of semiconductor material comprising a substrate covered by a layer of material, said device further comprising:
- a growth chamber (1) surrounding a process area (2), said growth chamber (1) comprising a lateral wall (3), a lower wall (4) and an upper wall (5) having each an inner surface,
- a main cryogenic panel having at least a lateral part (10) covering the inner surface of said lateral wall (3),
- a sample holder (6) able to support said substrate, said sample holder (6) comprising heating means,
- at least one effusion cell (8) able to evaporate atoms or molecules of elements or compounds,
- a gas injector (9) able to inject into the growth chamber (1) a gaseous precursor, a part of said gaseous precursor being able to react with the evaporated atoms or molecules of elements or compounds on the surface of the substrate to form the layer,
- pumping means (11) connected to the growth chamber (1) and able to provide high vacuum capability,
- an insulation enclosure (14) covering at least the inner surfaces of the growth chamber walls (3, 4, 5), said insulation enclosure (14) comprising:
- cold parts having a temperature Tₘᵢₙ inferior or equal to melting point of the gaseous precursor, said cold parts of the insulation enclosure (14) comprising:
- said lateral part of the main cryogenic panel (10) covering the inner surface of the lateral wall (3), and
- a lower part of the main cryogenic panel (23) covering the inner surface of the lower wall (4), said lower part of the main cryogenic panel (23) being provided with a first hole (24) for the effusion cell (8), and a second hole (25) for the gas injector (9), and
- hot parts having a temperature Tₘₐₓ superior or equal to a temperature wherein the desorption rate of said gaseous precursor on said hot parts is at least 1000 times greater than the adsorption rate of said gaseous precursor, said hot parts of the insulation enclosure (14) comprising:
- said effusion cell (8), and
- said gas injector (9), said gas injector (9) comprising heating means,
**characterised in that** it comprises a secondary cryogenic panel (7) and said lateral part of the main cryogenic panel (10) having an upper end (28), said cold parts of the insulation enclosure (14) comprising:
- a first thermal wing (17) linked to said upper end (28) of the lateral part of the main cryogenic panel (10), and
- a second thermal wing (18) linked to the outer wall of the secondary cryogenic panel (7), said two thermal wings (17, 18) extending transversally, surrounding the secondary cryogenic panel (7) and being close one to each other such as to insulate the process area (2) from the upper wall (5) of the growth chamber (1).

2. Molecular beam epitaxy apparatus according to claim 1, **characterised in that** said cold parts of the insulation enclosure (14) comprise a fourth thermal wing (20) positioned into the second hole (24) of the lower part of the main cryogenic panel (23) and extending from said hole (24).

3. Molecular beam epitaxy apparatus according to any one of claims 1 or 2, **characterised in that** said hot parts of the insulation enclosure (14) comprise a third thermal wing (19) linked to the gas injector (9), said third thermal wing (19) being positioned between the second hole (25) of the lower part of the main cryogenic panel (23) and the inner surface of the lower wall (4) of the growth chamber (1), and surrounding the gas injector (9) such as to insulate the process area (2) from the inner surface of the lower wall (4) of the growth chamber (1).

4. Molecular beam epitaxy apparatus according to any one of claims 1 to 3, **characterised in that** the effusion cell (8) is able to evaporate atoms or molecules of elements or compounds of the group III and the gas injector (9) is able to inject a gaseous precursor comprising an element of the group V.

5. Molecular beam epitaxy apparatus according to claim 4, **characterised in that** the substrate is a silicon substrate, the effusion cell (8) is able to evaporate gallium and the gas injector (9) is able to inject gaseous ammonia.

6. Molecular beam epitaxy apparatus according to claim 5, **characterised in that** the temperature of said cold parts Tₘᵢₙ is inferior or equal to - 78°C, and the temperature of said hot parts Tₘₐₓ is superior or equal to +100°C.

7. Molecular beam epitaxy apparatus according to any one of claims 1 to 6, **characterised in that** said lateral part of the main cryogenic panel (10) is provided with a hole (22) for the connection with the pumping means (11), said pumping means (11) comprising a pumping duct (30) having a wall (15), said cold parts of the insulation enclosure (14) comprising a cryogenic panel (16) covering the wall (15) inner surface of the pumping duct (30).

8. Molecular beam epitaxy apparatus according to any one of claims 1 to 7, **characterised in that** the insulation enclosure (14) covers at least 80% of the inner surfaces of the growth chamber walls (3, 4, 5) and the pumping duct (30) of the pumping means (11).

9. Molecular beam epitaxy apparatus according to any one of claims 1 to 8, **characterised in that** said effusion cell (8) comprises a shutter, said hot parts of the insulation enclosure (14) comprising said sample holder (6) and the shutter of the effusion cell.

10. Molecular beam epitaxy apparatus according to any one of claims 1 to 9, **characterised in that** the insulation enclosure (14) is separated from the growth chamber walls (3, 4, 5) by a space d, such that condensed precursor on cold parts of said insulation enclosure (14) does not touch said growth chamber walls (3, 4, 5).

11. Molecular beam epitaxy apparatus according to any one of claims 1 to 10, **characterised in that** the sample holder (6) is lower than the lower end (31) of the secondary cryogenic panel (7) for limiting or avoiding thermal exchanges between said sample holder (6) and the lower end (31) of said secondary cryogenic panel (7).

## Patentansprüche

1. Molekularstrahlepitaxie-Vorrichtung zur Herstellung von Wafern aus Halbleitermaterial, die ein von einer Materialschicht bedecktes Substrat umfassen, wobei die Vorrichtung weiterhin umfasst:
- eine Wachstumskammer (1), die einen Prozessbereich (2) umgibt, wobei die Wachstumskammer (1) eine Seitenwand (3), eine untere Wand (4) und eine obere Wand (5), die jeweils eine Innenfläche aufweisen, umfasst;
- eine kryogene Hauptplatte, von der wenigstens ein Seitenteil (10) die Innenfläche der Seitenwand (3) bedeckt;
- einen Probenhalter (6), der das Substrat tragen kann, wobei der Probenhalter (6) Heizeinrichtungen umfasst;
- wenigstens eine Effusionszelle (8), die Atome oder Moleküle von Elementen oder Verbindungen verdampfen kann;
- einen Gasinjektor (9), der einen gasförmigen Vorläufer in die Wachstumskammer (1) injizieren kann, wobei ein Teil des gasförmigen Vorläufers auf der Oberfläche des Substrats mit den verdampften Atomen oder Molekülen von Elementen oder Verbindungen unter Bildung der Schicht reagieren kann;
- Pumpeinrichtungen (11), die mit der Wachstumskammer (1) verbunden sind und für Hochvakuumfähigkeit sorgen können;
- eine Isolationskapsel (14), die wenigstens die Innenflächen der Wände (3, 4, 5) der Wachstumskammer bedeckt, wobei die Isolationskapsel (14) Folgendes umfasst:
- kalte Teile, die eine Temperatur Tₘᵢₙ von kleiner oder gleich dem Schmelzpunkt des gasförmigen Vorläufers aufweisen, wobei die kalten Teile der Isolationskapsel (14) Folgendes umfassen:
- den Seitenteil der kryogenen Hauptplatte (10), der die Innenfläche der Seitenwand (3) bedeckt; und
- einen unteren Teil der kryogenen Hauptplatte (23), der die Innenfläche der Seitenwand (4) bedeckt, wobei der untere Teil der kryogenen Hauptplatte (23) mit einem ersten Loch (24) für die Effusionszelle (8) und einem zweiten Loch (25) für den Gasinjektor (9) versehen ist; und
- heiße Teile, die eine Temperatur Tₘₐₓ von größer oder gleich einer Temperatur, bei der die Desorptionsrate des gasförmigen Vorläufers auf den heißen Teilen wenigstens 1000mal so groß ist wie die Adsorptionsrate des gasförmigen Vorläufers, aufweisen, wobei die heißen Teile der Isolationskapsel (14) Folgendes umfassen:
- die Effusionszelle (8) und
- den Gasinjektor (9), wobei der Gasinjektor (9) Heizeinrichtungen umfasst;
**dadurch gekennzeichnet, dass** sie eine sekundäre kryogene Platte (7) umfasst und der Seitenteil der kryogenen Hauptplatte (10) ein oberes Ende (28) aufweist, wobei die kalten Teile der Isolationskapsel (14) Folgendes umfassen:
- einen ersten thermischen Flügel (17), der mit dem oberen Ende (28) des Seitenteils der kryogenen Hauptplatte (10) verbunden ist; und
- einen zweiten thermischen Flügel (18), der mit der Außenwand der sekundären kryogenen Platte (7) verbunden ist, wobei sich die beiden thermischen Flügel (17, 18) in Querrichtung erstrecken, die sekundäre kryogene Platte (7) umgeben und einander so nahe sind, dass sie den Prozessbereich (2) gegenüber der oberen Wand (5) der Wachstumskammer (1) isolieren.

2. Molekularstrahlepitaxie-Vorrichtung gemäß Anspruch 1, **dadurch gekennzeichnet, dass** die kalten Teile der Isolationskapsel (14) einen vierten thermischen Flügel (20) umfassen, der sich in das zweite Loch (24) des unteren Teils der kryogenen Hauptplatte (23) hinein erstreckt und aus diesem Loch (24) herausragt.

3. Molekularstrahlepitaxie-Vorrichtung gemäß einem der Ansprüche 1 oder 2, **dadurch gekennzeichnet, dass** die heißen Teile der Isolationskapsel (14) einen dritten thermischen Flügel (19) umfassen, der mit dem Gasinjektor (9) verbunden ist, wobei sich der dritte thermische Flügel (19) zwischen dem zweiten Loch (25) des unteren Teils der kryogenen Hauptplatte (23) und der Innenfläche der unteren Wand (4) der Wachstumskammer (1) befindet und den Gasinjektor (9) so umgibt, dass er den Prozessbereich (2) gegenüber der Innenfläche der unteren Wand (4) der Wachstumskammer (1) isoliert.

4. Molekularstrahlepitaxie-Vorrichtung gemäß einem der Ansprüche 1 bis 3, **dadurch gekennzeichnet, dass** die Effusionszelle (8) Atome oder Moleküle von Elementen oder Verbindungen der Gruppe III verdampfen kann und der Gasinjektor (9) einen gasförmigen Vorläufer, der ein Element der Gruppe V umfasst, einleiten kann.

5. Molekularstrahlepitaxie-Vorrichtung gemäß Anspruch 4, **dadurch gekennzeichnet, dass** das Substrat ein Siliciumsubstrat ist, die Effusionszelle (8) Gallium verdampfen kann und der Gasinjektor (9) gasförmigen Ammoniak einleiten kann.

6. Molekularstrahlepitaxie-Vorrichtung gemäß Anspruch 5, **dadurch gekennzeichnet, dass** die Temperatur der kalten Teile Tₘᵢₙ kleiner oder gleich -78 °C ist und die Temperatur der heißen Teile Tₘₐₓ größer oder gleich +100 °C ist.

7. Molekularstrahlepitaxie-Vorrichtung gemäß einem der Ansprüche 1 bis 6, **dadurch gekennzeichnet, dass** der Seitenteil der kryogenen Hauptplatte (10) mit einem Loch (22) zur Verbindung mit der Pumpeinrichtung (11) versehen ist, wobei die Pumpeinrichtung (11) eine Pumpleitung (30) mit einer Wand (15) umfasst, wobei die kalten Teile der Isolationskapsel (14) eine kryogene Platte (16) umfassen, die die Innenfläche der Wand (15) der Pumpleitung (30) bedeckt.

8. Molekularstrahlepitaxie-Vorrichtung gemäß einem der Ansprüche 1 bis 7, **dadurch gekennzeichnet, dass** die Isolationskapsel (14) wenigstens 80% der Innenflächen der Wände (3, 4, 5) der Wachstumskammer und der Pumpleitung (30) der Pumpeinrichtung (11) bedeckt.

9. Molekularstrahlepitaxie-Vorrichtung gemäß einem der Ansprüche 1 bis 8, **dadurch gekennzeichnet, dass** die Effusionszelle (8) einen Verschluss umfasst, wobei die heißen Teile der Isolationskapsel (14) den Probenhalter (6) und den Verschluss der Effusionszelle umfassen.

10. Molekularstrahlepitaxie-Vorrichtung gemäß einem der Ansprüche 1 bis 9, **dadurch gekennzeichnet, dass** die Isolationskapsel (14) durch einen Zwischenraum d von den Wänden (3, 4, 5) der Wachstumskammer getrennt ist, so dass auf kalten Teilen der Isolationskapsel (14) kondensierter Vorläufer die Wände (3, 4, 5) der Wachstumskammer nicht berührt.

11. Molekularstrahlepitaxie-Vorrichtung gemäß einem der Ansprüche 1 bis 10, **dadurch gekennzeichnet, dass** der Probenhalter (6) tiefer liegt als das untere Ende (31) der sekundären kryogenen Platte (7), um einen Wärmeaustausch zwischen dem Probenhalter (6) und dem unteren Ende (31) der sekundären kryogenen Platte (7) zu begrenzen oder zu vermeiden.

## Revendications

1. Appareil pour épitaxie par jets moléculaires pour produire des galettes d'un matériau semi-conducteur, comprenant un substrat recouvert d'une couche de matériau, ledit dispositif comprenant en outre :
- une chambre de croissance (1) entourant une zone de traitement (2), ladite chambre de croissance (1) comprenant une paroi latérale (3), une paroi inférieure (4) et une paroi supérieure (5), chacune ayant une surface interne,
- un panneau cryogénique principal ayant au moins une partie latérale (10) recouvrant la surface interne de ladite paroi latérale (3),
- un porte-échantillon (6), capable de supporter ledit substrat, ledit porte-échantillon (6) comprenant des moyens de chauffage,
- au moins une cellule d'effusion (8), capable d'évaporer des atomes ou des molécules d'éléments ou de composés,
- un injecteur de gaz (9), capable d'injecter dans la chambre de croissance (1) un précurseur gazeux, une partie dudit précurseur gazeux étant capable de réagir avec les atomes ou molécules évaporés d'éléments ou de composés sur la surface du substrat, pour former ladite couche,
- des moyens de pompage (11), raccordé à la chambre de croissance (1) et capable de fournir une capacité de vide poussé,
- une enceinte d'isolement (14) recouvrant au moins les surfaces internes des parois (3, 4, 5) de la chambre de croissance, ladite enceinte d'isolement (14) comprenant :
- des parties froides ayant une température Tₘᵢₙ inférieure ou égale au point de fusion du précurseur gazeux, lesdites parties froides de l'enceinte d'isolement (14) comprenant :
- ladite partie latérale du panneau cryogénique principal (10) recouvrant la surface interne de la paroi latérale (3), et
- une partie inférieure du panneau cryogénique principal (23) recouvrant la surface interne de la paroi inférieure (4), ladite partie inférieure du panneau cryogénique principal (23) étant pourvue d'un premier trou (24) pour la cellule d'effusion (8) et d'un deuxième trou (25) pour l'injecteur de gaz (9), et
- des parties chaudes ayant une température Tₘₐₓ supérieure ou égale à une température à laquelle le taux de désorption dudit précurseur gazeux sur lesdites parties chaudes est au moins 1000 fois supérieur au taux d'adsorption dudit précurseur gazeux, lesdites parties chaudes de l'enceinte d'isolement (14) comprenant :
- ladite cellule d'effusion (8), et
- ledit injecteur de gaz (9), ledit injecteur de gaz (9) comprenant des moyens de chauffage,
**caractérisé en ce qu'**il comprend un panneau cryogénique secondaire (7) et ladite partie latérale du panneau cryogénique principal (10) ayant une extrémité supérieure (28), lesdites parties froides de l'enceinte d'isolement (14) comprenant :
- une première aile thermique (17), liée à ladite extrémité supérieure (28) de la partie latérale du panneau cryogénique principal (10), et
- une deuxième aile thermique (18), liée à la paroi extérieure du panneau cryogénique secondaire (7), lesdites deux ailes thermiques (17, 18) s'étendant transversalement, entourant le panneau cryogénique secondaire (7) et étant proches l'une de l'autre de façon à isoler la zone de traitement (2) de la paroi supérieure (5) de la chambre de croissance (1).

2. Appareil pour épitaxie par jets moléculaires selon la revendication 1, **caractérisé en ce que** lesdites parties froides de l'enceinte d'isolement (14) comprennent une quatrième aile thermique (20) disposée dans le deuxième trou (24) de la partie inférieure du panneau cryogénique principal (23) et s'étendant à partir dudit trou (24).

3. Appareil pour épitaxie par jets moléculaires selon l'une quelconque des revendications 1 ou 2, **caractérisé en ce que** lesdites parties chaudes de l'enceinte d'isolement (14) comprennent une troisième aile thermique (19) liée à l'injecteur de gaz (9), ladite troisième aile thermique (19) étant disposée entre le deuxième trou (25) de la partie inférieure du panneau cryogénique principal (23) et la surface interne de la paroi inférieure (4) de la chambre de croissance (1), et entourant l'injecteur de gaz (9) de façon à isoler la zone de traitement (2) de la surface interne de la paroi inférieure (4) de la chambre de croissance (1).

4. Appareil pour épitaxie par jets moléculaires selon l'une quelconque des revendications 1 à 3, **caractérisé en ce que** la cellule d'effusion (8) est capable d'évaporer des atomes ou des molécules d'éléments ou de composés du groupe III, et l'injecteur de gaz (9) est capable d'injecter un précurseur gazeux comprenant un élément du groupe V.

5. Appareil pour épitaxie par jets moléculaires selon la revendication 4, **caractérisé en ce que** le substrat est un substrat de silicium, la cellule d'effusion (8) est capable d'évaporer du gallium, et l'injecteur de gaz (9) est capable d'injecter de l'ammoniac gazeux.

6. Appareil pour épitaxie par jets moléculaires selon la revendication 5, **caractérisé en ce que** la température desdites parties froides Tₘᵢₙ est inférieure ou égale à -78°C, et la température desdites parties chaudes Tₘₐₓ est supérieure ou égale à +100°C.

7. Appareil pour épitaxie par jets moléculaires selon l'une quelconque des revendications 1 à 6, **caractérisé en ce que** ladite partie latérale du panneau cryogénique principal (10) est pourvue d'un trou (22) pour raccordement aux moyens de pompage (11), lesdits moyens de pompage (11) comprenant une conduite de pompage (30) ayant une paroi (15), lesdites parties froides de l'enceinte d'isolement (14) comprenant un panneau cryogénique (16) recouvrant la surface interne de la paroi (15) de la conduite de pompage (30).

8. Appareil pour épitaxie par jets moléculaires selon l'une quelconque des revendications 1 à 7, **caractérisé en ce que** l'enceinte d'isolement (14) recouvre au moins 80 % des surfaces internes des parois (3, 4, 5) de la chambre de croissance et de la conduite de pompage (30) des moyens de pompage (11).

9. Appareil pour épitaxie par jets moléculaires selon l'une quelconque des revendications 1 à 8, **caractérisé en ce que** ladite cellule d'effusion (8) comprend un obturateur, lesdites parties chaudes de l'enceinte d'isolement (14) comprenant ledit porte-échantillon (6) et l'obturateur de la cellule d'effusion.

10. Appareil pour épitaxie par jets moléculaires selon l'une quelconque des revendications 1 à 9, **caractérisé en ce que** l'enceinte d'isolement (14) est séparée des parois (3, 4, 5) de la chambre de croissance par un espace d tel que le précurseur condensé sur les parties froides de ladite enceinte d'isolement (14) ne touche pas lesdites parois (3, 4, 5) de la chambre de croissance.

11. Appareil pour épitaxie par jets moléculaires selon l'une quelconque des revendications 1 à 10, **caractérisé en ce que** le porte-échantillon (6) est plus bas que l'extrémité inférieure (31) du panneau cryogénique secondaire (7) pour limiter ou éviter des échanges thermiques entre ledit porte-échantillon (6) et l'extrémité inférieure (31) dudit panneau cryogénique secondaire (7).
